# EUROPEAN PATENT SPECIFICATION

(11) **EP 3 432 433 B1**
(45) Date of publication and mention of the grant of the patent: **22.03.2023**
(21) Application number: 16894497.3
(22) Date of filing: 08.09.2016
(51) Int. Cl.: H02H 3/34, G01R 29/18, H02H 7/127, H02M 7/12, G01R 31/52, G01R 31/54

(54) **POWER SUPPLY SYSTEM**
ENERGIEVERSORGUNGSSYSTEM
SYSTÈME D'ALIMENTATION ÉLECTRIQUE

(30) Priority: 15.03.2016 JP 2016051502
(43) Date of publication of application: 23.01.2019
(73) Proprietor: Fujitsu General Limited, Kanagawa 213-8502 (JP)
(72) Inventor: SASAKI, Shigeharu, Kawasaki-shi Kanagawa 213-8502 (JP)
(74) Representative: TBK
(86) International application number: PCT/JP2016/076520
(87) International publication number: WO 2017/158880

(56) References cited:
- EP-A2- 2 390 674
- CN-A- 1 455 263
- CN-U- 202 197 083
- JP-A- H09 284 985
- JP-A- H10 164 747
- JP-A- H10 336 881
- JP-A- H10 336 881
- JP-A- 2001 296 324
- JP-A- 2006 003 043
- JP-A- 2006 003 043
- JP-A- 2011 169 747
- JP-A- 2011 169 747
- JP-A- 2011 247 497
- JP-A- 2015 194 447
- JP-A- 2015 194 447
- KR-A- 20140 013 646
- KR-A- 20140 121 593
- BASU K P ET AL: "Mitigation of power supply disturbance in electronic loads", ENERGY, AUTOMATION, AND SIGNAL (ICEAS), 2011 INTERNATIONAL CONFERENCE ON, IEEE, 28 December 2011 (2011-12-28), pages 1-5, XP032113354, DOI: 10.1109/ICEAS.2011.6147127 ISBN: 978-1-4673-0137-4
- BHIM SINGH ET AL: "New control approach for capacitor supported DSTATCOM in three-phase four wire distribution system under non-ideal supply voltage conditions based on synchronous reference frame theory", INTERNATIONAL JOURNAL OF ELECTRICAL POWER & ENERGY SYSTEMS, JORDAN HILL, OXFORD, GB, vol. 33, no. 5, 5 December 2010 (2010-12-05), pages 1109-1117, XP028407729, ISSN: 0142-0615, DOI: 10.1016/J.IJEPES.2010.12.006 [retrieved on 2011-01-17]

## Description

### Technical Field

The present invention relates to a power converter and a power supply system which are capable of reliably detecting an open phase and a reverse phase of each phase even when a power conversion module that converts output power of three phases except for an N-phase of a three-phase four-wire power supply coexists with a main control power generation unit that generates main control power by using the N-phase and one of three phases of the three-phase four-wire power supply.

### Background Art

In the related art, in a case where the operation of a motor or the like as a load is controlled, a power converter such as a converter or an inverter is used. In the power converter, a power supply for driving a switching element and the like is necessary.

Here, PTL 1 discloses an air conditioner connected to a three-phase three-wire power supply, in which a power supply wire is so connected that at least one of an indoor unit and an indoor control unit can fall into a malfunction state when an open phase occurs even in one phase of the three phase three wires, so that a circuit for detecting an open phase is made unnecessary.

PTL 2 discloses an air conditioner connected to a three-phase three-wire power supply, in which determination of an open phase of any one phase of the three phase three wires is performed according to whether the voltage between two phases of the three phase three wires is at a predetermined level or not.

### Citation List

### Patent Literature

[PTL 1] Japanese Laid-on Patent Publication No. H09-284985
[PTL 2] Japanese Laid-on Patent Publication No. H10-164747

Document KR 2014 0121593 A discloses a power quality recovery relay, which serves to recover the quality of power to normal power which has been degraded due to a failure such as an open-phase or a reverse phase of a power line. The power quality recovery relay is connected to a power supply apparatus, which supplies power through a distribution system, and includes a control unit, which outputs a control signal to operate a switch connected to the power line in order to recover the open phase and the reverse phase to the normal when the open-phase and reverse-phase states are detected.

EP 2 390 674 A2 discloses an air conditioner, wherein the air conditioner receives power from a three-phase four-wire system. A DC converter receives three phases by which a motor (CM) is driven via an inverter. A controller main portion for controlling the inverter is powered by an L1 phase of the three phases and the N phase. Moreover, a current sensor (current transformer) is provided for the N phase, and a current sensor (current transformer) is provided for the L1 phase. By means of the two current transformers, an N phase loss abnormality is detected.

Document JP 2011 169747 A discloses a circuit board for open-phase detection, wherein this circuit board is provided in order to perform open-phase detection for both three-phase three-wire AC power supply and three-phase four-wire AC power supply.

### Summary of Invention

### Technical Problem

Incidentally, the inventor of the present application has found that in an air conditioner, in a case where AC power supplied from a three-phase four-wire power supply having an R-phase, an S-phase, a T-phase, and an N-phase is converted to DC power by a power conversion module with all of the R-phase, the S-phase, the T-phase, and the N-phase connected to the power conversion module, a noise filter is required to be provided for all the four wires, and thus a problem occurs in that the noise filter becomes large and complicated. As means for solving the problem, the inventor has connected three phase three wires, which are obtained by separating the N-phase from the three-phase four-wire power supply, to a power conversion module through a three-phase three-wire noise filter. In addition, since the power for driving the power conversion module is required to be generated based on a voltage of 200 V, the inventor has obtained the voltage of 200 V between a middle point of filter capacitors connected by star connection to the respective three phase three wires and a wire of any one phase of the three phase three wires (Japanese Patent Application No. 2015-214497).

Meanwhile, for example, a compressor, a fan motor, a four-way valve, and the like provided in an outdoor unit of an air conditioner are controlled by a control unit which is driven by a control power supply formed by a main control power generation unit in a main control power supply board. The main control power generation unit obtains a voltage of 200 V from an N-phase of the three-phase four-wire power supply and one phase among the respective three phases except for the N phase.

Here, only the three phases except for the N-phase of the three-phase four-wire power supply are connected to the power conversion module, and thus it is impossible to detect the open phase of the N-phase. Therefore, in a case where the open phase occurs in the N-phase, the main control power generation unit is not able to supply power, and the main control unit is not able to be operated, but the power conversion module does not use the N-phase, and thus a new problem in that the power conversion module is normally driven continuously occurs.

The invention has been made in consideration of the above described circumstances, and an object of the invention is to provide a power supply system which is capable of reliably detecting an open phase and a reverse phase of each phase even when a power conversion module that converts output power of three phases except for an N-phase of a three-phase four-wire power supply coexists with a main control power generation unit that generates main control power by using the N-phase and one of three phases of the three-phase four-wire power supply.

### Solution to Problem

This object is solved by a power supply system as defined in claim 1.

Advantageous developments are defined in the dependent claims.

### Advantageous Effects of Invention

According to the invention, an N-phase open phase detection unit that is connected to an N-phase to detect an open phase of the N-phase is provided in the power converter. As a result, it is possible to reliably detect an open phase and a reverse phase of each phase even when a power conversion module that converts output power of three phases of a three-phase four-wire power supply coexists with a main control power generation unit that generates main control power by using the N-phase and one of three phases of the three-phase four-wire power supply.

### Brief Description of Drawings

Fig. 1 is a diagram illustrating a configuration of a power supply system according to an embodiment of the invention.
Fig. 2 is a diagram illustrating a configuration of a
power supply system according to a modification example of an embodiment of the invention.

### Description of Embodiments

Hereinafter, an embodiment of the invention will be described with reference to accompanying drawings.

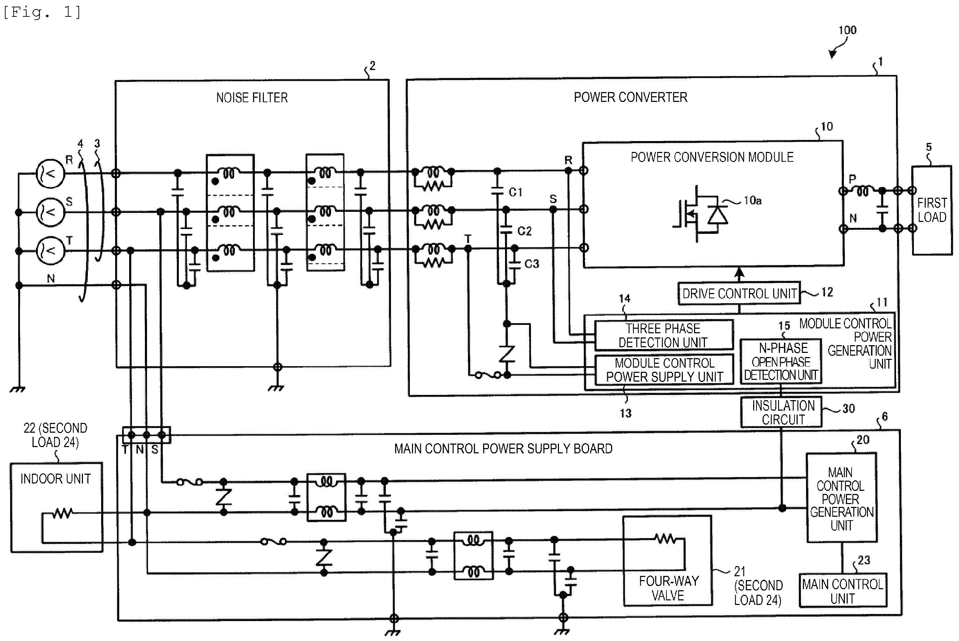

Fig. 1 is a diagram illustrating a configuration of a power supply system 100 according to an embodiment of the invention. As illustrated in Fig. 1, the power supply system 100 includes a power converter 1 that converts AC power to DC power to supply the DC power to a load (a first load 5) such as a brushless DC motor, an inverter, and the like mounted on, for example, a compressor. The power converter 1 converts power, which is input through a noise filter 2 for three phase three wires 3 from three phases (an R-phase, an S-phase, and a T-phase) of a three-phase four-wire (an R-phase, an S-phase, a T-phase, and an N-phase) power supply 4, to DC power between P and N, and the power is supplied through the power converter 1 to the load (the first load 5) such as a brushless DC motor, an inverter, and the like mounted on, for example, a compressor.

The power converter 1 includes a power conversion module 10. The power conversion module 10 controls driving of an active element 10a such as a switching element to convert an input three-phase AC power to a desired DC power and output the desired DC power. As described above, the power conversion module 10 converts the three-phase AC power to the DC power which is generated between P and N. In Fig. 1, although the power conversion module 10 functions as a converter, it may function as an AC-to-AC converter that converts the three-phase AC power to a two-phase or three-phase AC power. In addition, the power conversion module 10 may include a converter and an inverter. Furthermore, the power conversion module 10 may be a matrix converter.

The power converter 1 includes a module control power generation unit 11 and a drive control unit 12. The module control power generation unit 11 includes a module control power supply unit 13, a three phase detection unit 14, and an N-phase open phase detection unit 15. The module control power supply unit 13 generates a drive control power for driving the power conversion module 10 from the three-phase three wires 3 with an interphase voltage of 400 V. The module control power supply unit 13 generates the drive control power from a voltage (200 V) between one (for example, the T-phase) of the three phases and a middle point between capacitors C1, C2, and C3 which are connected by star connecttion to the three phases (the R-phase, the S-phase, and the T-phase).

For example, the three phase detection unit 14 detects an open phase and a reverse phase of each phase based on a phase difference between voltages of two of the three phases. However, the N-phase is not connected to the three phase detection unit 14. Therefore, in a case where the three phases (the R-phase, the S-phase, and the T-phase) are normally connected, the three phase detection unit 14 is not able to detect the open phase of the N-phase. In order to detect the open phase of the N-phase which is not connected to the three phase detection unit 14, an N-phase open phase detection unit 15 is provided in the power converter 1. The N-phase open phase detection unit 15 detects the open phase of the N-phase by detecting a voltage of the N-phase of the three-phase four-wire power supply 4. For example, the N-phase open phase detection unit 15 detects the open phase of the N-phase by detecting an interphase voltage between the N-phase and any one of the three phases (the R-phase, the S-phase, and the T-phase).

The drive control unit 12 controls driving of the active element 10a included in the power conversion module 10 by using the drive control power which is generated by the module control power supply unit 13, and stops driving of the power conversion module 10 in a case where the three phase detection unit 14 detects the open phase or the reverse phase or in a case where the N-phase open phase detection unit 15 detects the open phase of the N-phase.

On the other hand, a main control power supply board 6 outside the power converter 1 is provided in an outdoor unit which forms, for example, an air conditioner. The main control power supply board 6 supplies power to, for example, a load such as a four-way valve 21 or an indoor unit 22, to which power is supplied without passing through the power converter 1, or an outdoor unit blower fan, which is not illustrated, or the like (hereinafter, these are generically referred to as a second load 24), or supplies power to, for example, a main control power generation unit 20 or the like that generates power which is supplied to a main control unit 23 that controls the first load 5 or the second load 24 to which power is supplied through the power converter 1. The N-phase of the three-phase four-wire power supply 4 including the N-phase in addition to the three-phase three wires 3 and two (for example, the S-phase and the T-phase) of the three phases are drawn into the main control power supply board 6. The main control power generation unit 20 generates power which is supplied to a device connected to the main control power supply board based on the interphase voltage (200 V) between the N-phase and the S-phase. In addition, the four-way valve 21 and the indoor unit 22 directly receive power supply from the N-phase of the three-phase four-wire power supply 4 and one (for example, the T-phase) of the three phases through the main control power supply board 6.

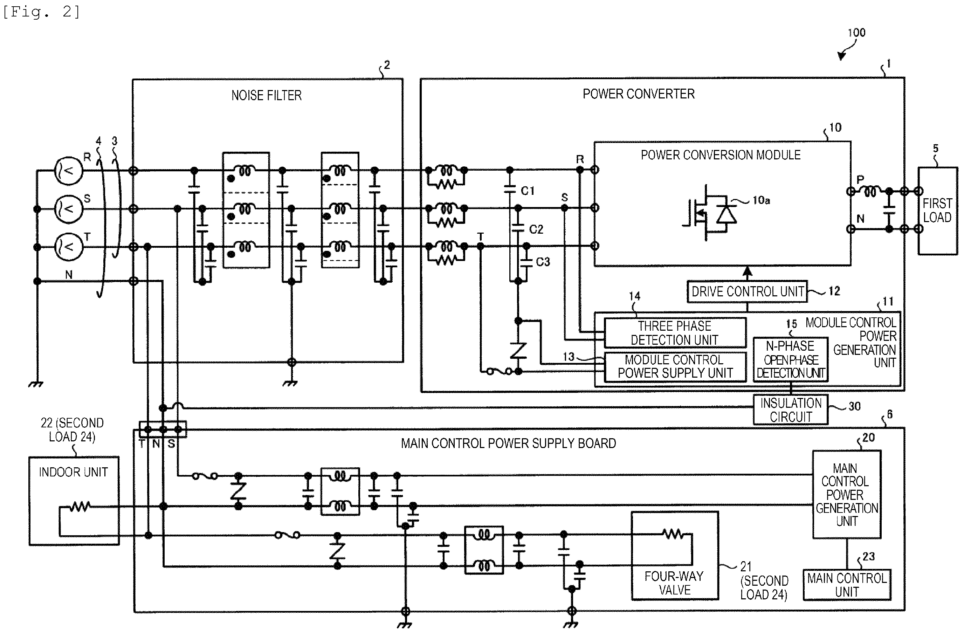

Here, as illustrated in Fig. 1, the N-phase in the main control power supply board 6 is connected to the N-phase open phase detection unit 15 through an insulation circuit 30. However, the invention is not limited to this embodiment, and for example, as illustrated in Fig. 2, the N-phase outside the main control power supply board 6 may be connected to the N-phase open phase detection unit 15 through the insulation circuit 30. In any of the embodiments, the N-phase open phase detection unit 15 detects the N-phase voltage and determines the presence of the open phase of the N-phase according to the detected N-phase voltage value. It is preferable that the N-phase open phase detection unit 15 determines that the open phase occurs in a case where the interphase voltage between the N-phase and any one of the three phases (the R-phase, the S-phase, and the T-phase) becomes a predetermined value or less a predetermined number of times in a predetermined time. This is for preventing an erroneous determination because the voltage value of the N-phase is temporarily reduced by noise or the like in some cases. In the determination of the open phase of the N-phase, for example, at the time of start of an air conditioner, it is determined that the open phase of the N-phase occurs, in a case where a start sequence, in which the interphase voltage between the N-phase and any one (for example, the R-phase) of the three phases is detected by the N-phase open phase detection unit 15 and indicated to be 200 V and then for one minute after the start of driving of the second load 24 (the four-way valve 21, the indoor unit 22, or the like), the interphase voltage between the N-phase and the R-phase decreases to a voltage equal to or less than the level at which the control of the main control unit 23 can be maintained, so that the air conditioner is restarted, is repeated twice or more.

In addition, the insulation circuit 30 may be an insulation transformer or a photo coupler.

As described above, in the embodiment, the N-phase open phase detection unit 15 that detects the N-phase voltage of the main control power supply board 6 using the N-phase and thus detects the open phase of the N-phase is provided in the power converter 1. As a result, even in a case where the N-phase becomes an open phase so that power is not supplied to the second load 24 and the power supply system 100 is not able to be operated, the power converter 1 can detect the open phase of the N-phase to ensure reliable detection of the open phase of the N-phase. In addition, in a case where the power converter 1 detects the open phase of the N-phase, the power converter 1 stops the operation thereof. Therefore, it is possible to prevent a situation in which only the power converter 1 is continuously driven even though the power supply system 100 is not able to be operated. Further, when the N-phase open phase detection unit 15 is configured to detect the N-phase voltage through the insulation circuit 30, the power converter 1 can detect the N-phase voltage without leakage of noise to the outside from the power converter 1.

### Reference Signs List

1: power converter
2: noise filter
3: three phase three wires
4: three-phase four-wire power supply
5: first load
6: main control power supply board
10: power conversion module
10a: active element
11: module control power generation unit
12: drive control unit
13: module control power supply unit
14: three phase detection unit
15: N-phase open phase detection unit
20: main control power generation unit
21: four-way valve
22: indoor unit
23: main control unit
24: second load
30: insulation circuit
100: power supply system
C1, C2, C3: capacitor

## Claims

1. A power supply system (**100**) comprising:
a power converter (**1**) comprising:
a power conversion module (**10**) that converts output power from three phases, except for an N-phase, of a three-phase four-wire power supply having an R-phase, an S-phase, a T-phase, and an N-phase;
a module control power supply unit (**13**) that generates, from the output power of the three phases, drive control power for driving the power conversion module (**10**);
a three phase detection unit (**14**) that detects an open phase and a reverse phase of each phase based on a phase difference between two of the three phases by using the module control power supply unit as a power supply;
a drive control unit (**12**) that controls driving of the power conversion module (**10**) by using the drive control power generated by the module control power supply unit (**13**) as a power source; and
an N-phase open phase detection unit (**15**) that detects an open phase of the N-phase by using the drive control power as a power source;
a load (**5**) connected to the power converter (**1)**; and
a main control power generation unit (**20**) that generates, from the N-phase and one of the three phases, power for a main control unit (**23**) that controls the load (**5**),
wherein the N-phase open phase detection unit (**15**) detects the open phase of the N-phase based on a voltage of the N-phase.

2. The power supply system (**100**) according to claim 1, wherein the N phase open phase detection unit (**15**) is connected to an N phase in a main control power supply board (**6**) including the main control power generation unit (**20**).

3. The power supply system (**100**) according to claim 1,
wherein the drive control unit (**12**) stops driving of the power conversion module (**10**) in a case where the three phase detection unit (**14**) detects the open phase or the reverse phase of each of the three phases or in a case where the N-phase open phase detection unit (**15**) detects the open phase of the N-phase.

4. The power supply system (**100**) according to claim 2,
wherein the drive control unit (**12**) stops driving of the power conversion module (**10**) in a case where the three phase detection unit (**14**) detects the open phase or the reverse phase of each of the three phases or in a case where the N-phase open phase detection unit (**15**) detects the open phase of the N-phase.

5. The power supply system (**100**) according to any one of claims 1 to 4,
wherein the N-phase open phase detection unit and the N-phase are connected to each other through an insulation circuit (**30**).

6. The power supply system (**100**) according to any one of claims 1 to 4,
wherein the N-phase open phase detection unit (**15**) determines that the open phase occurs in a case where an interphase voltage between any one of the R-phase, the S-phase, and the T-phase and the N-phase becomes a predetermined value or less a predetermined number of times in a predetermined time.

7. The power supply system (**100**) according to claim 5,
wherein the N-phase open phase detection unit (**15**) determines that the open phase occurs in a case where an interphase voltage between any one of the R-phase, the S-phase, and the T-phase and the N-phase becomes a predetermined value or less a predetermined number of times in a predetermined time.

## Patentansprüche

1. Leistungsversorgungssystem (**100**), das aufweist:
einen Leistungswandler (**1**) mit:
einem Leistungsumwandlungsmodul (**10**), das Ausgangsleistung aus drei Phasen, mit Ausnahme einer N-Phase, einer Drei-Phasen-Vier-Draht-Leistungsversorgung umwandelt, die eine R-Phase, eine S-Phase, eine T-Phase und eine N-Phase aufweist,
einer Modulsteuerungsleistungsversorgungseinheit (**13**), die aus der Ausgangsleistung der drei Phasen eine Ansteuerungs-Steuerungsleistung zur Ansteuerung des Leistungsumwandlungsmoduls (**10**) erzeugt,
einer Drei-Phasen-Erfassungseinheit (**14**), die eine offene Phase und eine umgekehrte Phase jeder Phase auf der Grundlage einer Phasendifferenz zwischen zwei der drei Phasen durch Verwendung der Modulsteuerungsleistungsversorgungseinheit als eine Leistungsversorgung erfasst,
einer Ansteuerungs-Steuerungseinheit (**12**), die eine Ansteuerung des Leistungsumwandlungsmoduls (**10**) durch Verwendung der Ansteuerungs-Steuerungsleistung steuert, die durch die Modulsteuerungsleistungsversorgungseinheit (**13**) als eine Leistungsquelle erzeugt wird, und
einer N-Phase-Offen-Phase-Erfassungseinheit (**15**), die eine offene Phase der N-Phase durch Verwendung der Ansteuerungs-Steuerungsleistung als eine Leistungsquelle erfasst,
eine Last (**5**), die mit dem Leistungswandler (**1**) verbunden ist, und
eine Hauptsteuerungsleistungserzeugungseinheit (**20**), die aus der N-Phase und einer der drei Phasen Leistung für eine Hauptsteuerungseinheit (**23**) erzeugt, die die Last (**5**) steuert,
wobei die N-Phase-Offen-Phase-Erfassungseinheit (**15**) die offene Phase der N-Phase auf der Grundlage einer Spannung der N-Phase erfasst.

2. Leistungsversorgungssystem (**100**) nach Anspruch 1, wobei die N-Phase-Offen-Phase-Erfassungseinheit (**15**) mit einer N-Phase in einer Hauptsteuerungsleistungsversorgungsbaugruppe (**6**), die die Hauptsteuerungsleistungserzeugungseinheit (**20**) aufweist, verbunden ist.

3. Leistungsversorgungssystem (**100**) nach Anspruch 1,
wobei die Ansteuerungs-Steuerungseinheit (**12**) eine Ansteuerung des Leistungsumwandlungsmoduls (**10**) in einem Fall, in dem die Drei-Phasen-Erfassungseinheit (**14**) die offene Phase oder die umgekehrte Phase in jeder der Phasen erfasst, oder in einem Fall, in dem die N-Phase-Offen-Phase-Erfassungseinheit (**15**) die offene Phase der N-Phase erfasst, stoppt.

4. Leistungsversorgungssystem (**100**) nach Anspruch 2,
wobei die Ansteuerungs-Steuerungseinheit (**12**) eine Ansteuerung des Leistungsumwandlungsmoduls (**10**) in einem Fall, in dem die Drei-Phasen-Erfassungseinheit (**14**) die offene Phase oder die umgekehrte Phase in jeder der Phasen erfasst, oder in einem Fall, in dem die N-Phase-Offen-Phase-Erfassungseinheit (**15**) die offene Phase der N-Phase erfasst, stoppt.

5. Leistungsversorgungssystem (**100**) nach einem der Ansprüche 1 bis 4,
wobei die N-Phase-Offen-Phase-Erfassungseinheit und die N-Phase miteinander durch eine Isolierschaltung (**30**) verbunden sind.

6. Leistungsversorgungssystem (**100**) nach einem der Ansprüche 1 bis 4,
wobei die N-Phase-Offen-Phase-Erfassungseinheit **(15)** in einem Fall, in dem eine Zwischen-Phasen-Spannung zwischen irgendeiner der R-Phase, der S-Phase sowie der T-Phase und der N-Phase eine vorbestimmter Wert oder weniger für eine vorbestimmte Anzahl von Malen in einer vorbestimmten Zeit wird, bestimmt, das die offene Phase auftritt.

7. Leistungsversorgungssystem (**100**) nach Anspruch 5,
wobei die N-Phase-Offen-Phase-Erfassungseinheit (**15**) in einem Fall, dass eine Zwischen-Phasen-Spannung zwischen irgendeiner der R-Phase, der S-Phase sowie der T-Phase und der N-Phase ein vorbestimmter Wert oder weniger für eine vorbestimmte Anzahl von Malen in einer vorbestimmten Zeit wird, bestimmt, dass die offene Phase auftritt.

## Revendications

1. Système d'alimentation électrique (100) comprenant :
un convertisseur de puissance (1), comprenant :
un module de conversion de puissance (10) qui convertit une puissance de sortie venant de trois phases, à l'exception d'une phase N, d'une alimentation électrique triphasée à quatre fils ayant une phase R, une phase S, une phase T et une phase N ;
une unité d'alimentation électrique de commande de module (13) qui génère, à partir de la puissance de sortie des trois phases, une alimentation de commande d'excitation pour exciter le module de conversion de puissance (10) ;
une unité de détection de trois phases (14) qui détecte une phase ouverte et une phase inverse de chaque phase en se basant sur une différence de phase entre deux des trois phases en utilisant l'unité d'alimentation électrique de commande de module comme alimentation électrique ;
une unité de commande d'excitation (12) qui commande l'excitation du module de conversion de puissance (10) en utilisant l'alimentation de commande d'excitation générée par l'unité d'alimentation électrique de commande de module (13) comme source d'alimentation ; et
une unité de détection de phase ouverte de phase N (15) qui détecte une phase ouverte de la phase N en utilisant l'alimentation de commande d'excitation comme source d'alimentation ;
une charge (5) connectée au convertisseur de puissance (1) ; et
une unité de génération d'alimentation de commande principale (20) qui génère, à partir de la phase N et d'une des trois phases, une alimentation pour une unité de commande principale (23) qui commande la charge (5),
l'unité de détection de phase ouverte de la phase N (15) détectant la phase ouverte de la phase N en se basant sur une tension de la phase N.

2. Système d'alimentation électrique (100) selon la revendication 1, dans lequel l'unité de détection de phase ouverte de la phase N (15) est connectée à une phase N dans une carte d'alimentation électrique de commande principale (6) comprenant l'unité de génération d'alimentation de commande principale (20).

3. Système d'alimentation électrique (100) selon la revendication 1,
dans lequel l'unité de commande d'excitation (12) arrête l'excitation du module de conversion de puissance (10) dans un cas l'unité de détection de trois phases (14) détecte la phase ouverte ou la phase inverse de chacune des trois phases ou dans un cas où l'unité de détection de phase ouverte de la phase N (15) détecte la phase ouverte de la phase N.

4. Système d'alimentation électrique (100) selon la revendication 2,
dans lequel l'unité de commande d'excitation (12) arrête l'excitation du module de conversion de puissance (10) dans un cas où l'unité de détection de trois phases (14) détecte la phase ouverte ou la phase inverse de chacune des trois phases ou dans un cas où l'unité de détection de phase ouverte de la phase N (15) détecte la phase ouverte de la phase N.

5. Système d'alimentation électrique (100) selon l'une quelconque des revendications 1 à 4,
dans lequel l'unité de détection de phase ouverte de la phase N et la phase N sont connectées l'une à l'autre par l'intermédiaire d'un circuit d'isolation (30).

6. Système d'alimentation électrique (100) selon l'une quelconque des revendications 1 à 4,
dans lequel l'unité de détection de phase ouverte de la phase N (15) détermine que la phase ouverte se produit dans un cas ou une tension entre phases entre une quelconque de la phase R, de la phase S, et de la phase T et la phase N devient une valeur prédéterminée ou moins un nombre de fois prédéterminé en un temps prédéterminé.

7. Système d'alimentation électrique (100) selon la revendication 5,
dans lequel l'unité de détection de phase ouverte de la phase N (15) détermine que la phase ouverte se produit dans un cas ou une tension entre phases entre une quelconque de la phase R, de la phase S, et de la phase T et la phase N devient une valeur prédéterminée ou moins un nombre de fois prédéterminé en un temps prédéterminé.
